**Europäisches Patentamt**

**European Patent Office**

**Office européen des brevets**

(19)

(11) Veröffentlichungsnummer : **0 065 683**
**B1**

(12) **EUROPÄISCHE PATENTSCHRIFT**

(45) Veröffentlichungstag der Patentschrift :
12.02.86

(51) Int. Cl.⁴ : **G 01 R 23/00**

(21) Anmeldenummer : **82103953.4**

(22) Anmeldetag : **06.05.82**

(54) Verfahren und Schaltung zum Messen der Frequenz einer elektrischen Wechselgrösse.

(30) Priorität : **22.05.81 DE 3120525**

(43) Veröffentlichungstag der Anmeldung :
**01.12.82 Patentblatt 82/48**

(45) Bekanntmachung des Hinweises auf die Patenterteilung : **12.02.86 Patentblatt 86/07**

(84) Benannte Vertragsstaaten :
**BE CH FR LI NL SE**

(56) Entgegenhaltungen :
**DE-A- 2 557 906**
**DE-A- 2 720 023**
**DE-B- 2 548 799**

(73) Patentinhaber : **Siemens Aktiengesellschaft**
**Berlin und München Wittelsbacherplatz 2**
**D-8000 München 2 (DE)**

(72) Erfinder : **Kaufhold, Wolfgang, Dipl.-Ing.**
**Lannersberg 15**
**D-8520 Erlangen (DE)**

**Beschreibung**

Die Erfindung betrifft ein Verfahren zum Messen der Frequenz einer elektrischen Wechselgröße nach dem Oberbegriff des Anspruches 1.

Aus der DE-A-27 20 023 ist ein Verfahren zum Messen der Frequenz, bzw. der reziproken Frequenz einer mit Oberschwingungen behafteten Wechselspannung unter Ausnutzung ihrer Nulldurchgänge bekannt, bei der die Wechselspannung in ein kontinuierliches Ausgangssignal mit rechteckförmigem Verlauf umgewandelt wird, dessen Flanken von den Nulldurchgängen der Wechselspannung festgelegt sind, sodaß das Ausgangssignal die gleiche Frequenz wie die Wechselspannung hat. Dieses Ausgangssignal wird durch einen Frequenzumformer in ein kontinuierliches Rechtecksignal mit ganzzahlig verkleinerter Frequenz umgewandelt, das heißt verlangsamt, und einem von einem Oszillator als unabhängiger Taktgeber gesteuerten Zähler zugeführt, in dem jede Anstiegsflanke des Rechtecksignals eine Zählung der Zählimpulse des Oszillators veranlaßt und jede nachfolgende Abfallflanke des Rechtecksignals eine Abschaltung des Zählers bewirkt und gleichzeitig für eine Übertragung des Zählerstandes in ein speicherndes Register sorgt.

Der Zählerstand ist somit ein Maß für den Abstand benachbarter Flanken des Rechtecksignals mit verringerter Frequenz und damit ein Maß für die reziproke Frequenz (Periodendauer $T$). Der Speicherwert des Registers wird in einem Digital-Analog-Wandler in ein analoges Signal umgesetzt, das als von Oberschwingungen unbeeinflußte Ausgangsspannung der Periodendauer proportional ist. Durch Zuführung dieser Ausgangsspannung auf ein Reziprokglied kann eine der Frequenz proportionale oberschwingungsfreie Spannung gewonnen werden. Die Totzeit der Frequenzerfassung beträgt eine volle Periodendauer der Wechselspannung, über deren Amplitudenverläufe keinerlei Angaben gemacht sind und deren Frequenz der üblichen Netzfrequenz (z. B. 50 Hz) entspricht, worauf auch die ganzzahlige Verringerung durch den Frequenzumformer hindeutet.

Der Erfindung liegt die Aufgabe zugrunde, mit dem eingangs genannten Verfahren die nur einige Hertz betragende Frequenz einer elektrischen Wechselgröße mit stark schwankender und oftmals in ihrem Anfangswert nicht bekannten Amplitude, das heißt, eine um eine Größenordnung kleinere Frequenz als die Netzfrequenz unter Ermittlung der jeweiligen Amplitude innerhalb jeder Halbperiode zu messen.

Die Lösung der gestellten Aufgabe gelingt durch die Merkmale im Kennzeichen des Patentanspruches 1.

Eine Schaltung zur Durchführung des Verfahrens weisen hierzu die kennzeichnenden Merkmale des Patentanspruches 2 auf.

Die zu messende Wechselgröße wird hochverstärkt und gleichgerichtet und ihr jeweiliger Betrag mit einem von den Verstärkereigenschaften bestimmten Maximalwert verglichen, wobei beim jeweiligen Überschreiten des Maximalwertes durch den Betrag der zunehmenden Wechselgröße der Verstärkungsfaktor jeweils um eine Stufe zurückgenommen wird, bis der Betrag des Scheitelwertes der Wechselgröße erreicht und vorzugsweise gleich dem Maximalwert ist. Die einzelnen Stufen der Rücknahme des Verstärkungsfaktors innerhalb jeder halben Periode der Wechselgröße werden gespeichert und die jeweils folgende Stufe in ihrer Größe von der Größe der vorher gespeicherten Stufe abhängig gemacht, so daß die Rücknahme des Verstärkungsfaktors in jeder Halbwelle in immer kleineren Stufen erfolgt. Um den Scheitelwert der zu messenden Wechselgröße zu erkennen, wird der Betrag des ansteigenden Teiles der Wechselgröße in diskrete Einzelwerte zerlegt und diese zur Amplitudendifferenzbildung benutzt. Bei zu Null werdender Amplitudendifferenz ist der Scheitelwert erreicht, wobei dieser Scheitelwert bei kleinem Eingangssignalwert unterhalb des durch die Verstärkereigenschaften bedingten Maximalwertes liegen kann. Für diesen Fall ist ein Heraufsetzen der Verstärkung um eine Stufe durch einen ansprechenden Grenzwertmelder mit nachgeordnetem Impulsgeber vorgesehen, wobei der neue Scheitelwert durch einen von dem Impulsgeber ebenfalls angeregten Proben-Stufenspeicher übernommen wird. Die Zahl der Minderungsstufen des Verstärkungsfaktors kann vorteilhafterweise gezählt werden.

Aus dem Scheitelwert und einem späteren geringeren Betrag der Meßgröße wird eine Spannungsdifferenz gebildet, die mit dem Quotienten $\varepsilon$ aus einer mit gleicher Stufenzahl synchron abnehmend verstärkten Gleichgröße und dem Scheitelwert verglichen wird. Aus der Zeitspanne $\Delta t$ vom Erreichen des Scheitelwertes bis zur Zunahme der Spannungsdifferenz auf den Quotienten $\varepsilon$ läßt sich gemäß der Beziehung $T = (2\pi \, \Delta t)/\cos(1 - \varepsilon)$ die Periodendauer $T$ ermitteln.

Die Zeitgrösse $\Delta t$ kann durch Impulszählung bei festgelegter Impulsdauer und -frequenz ermittelt und durch Umwandlung der gezählten Impulse in einem Digital-Analog-Wandler an eine Spannung und diese durch Verstärkung mit $2\pi/\cos(1 - \varepsilon)$ in eine der halben Periodendauer proportionale konstante elektrische Gleichgröße umgeformt werden.

Weitere Einzelheiten der Erfindung sind nachfolgend an Hand eines Ausführungsbeispiels näher erläutert. Es zeigt

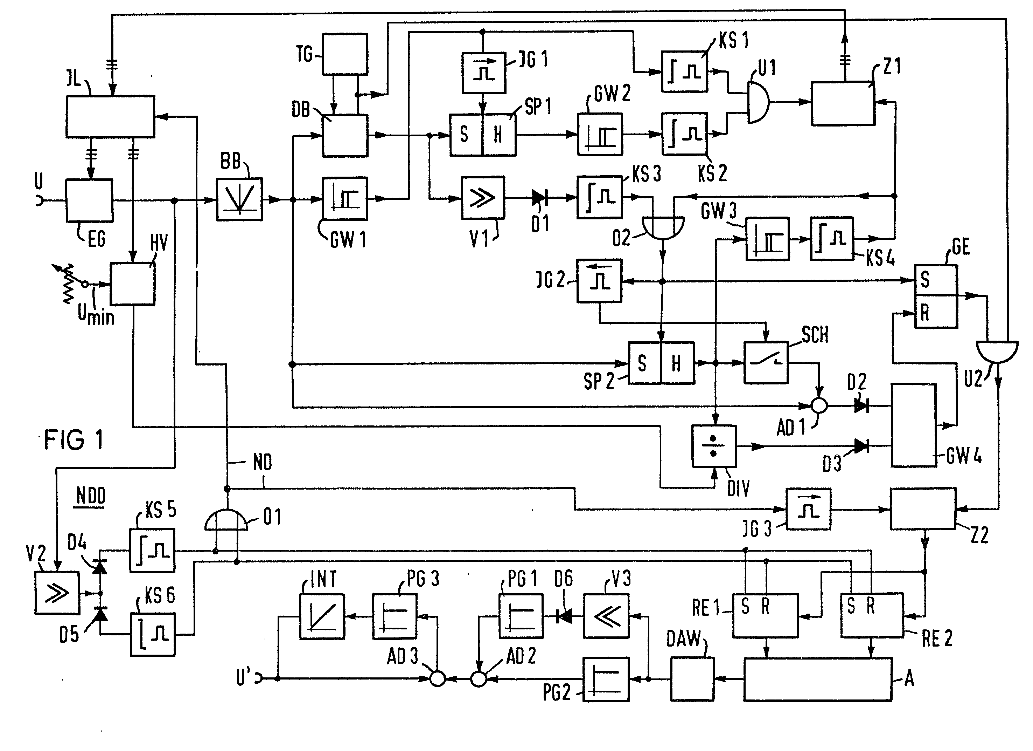

Figur 1 eine schematisch dargestellte Schaltung nach der Erfindung und

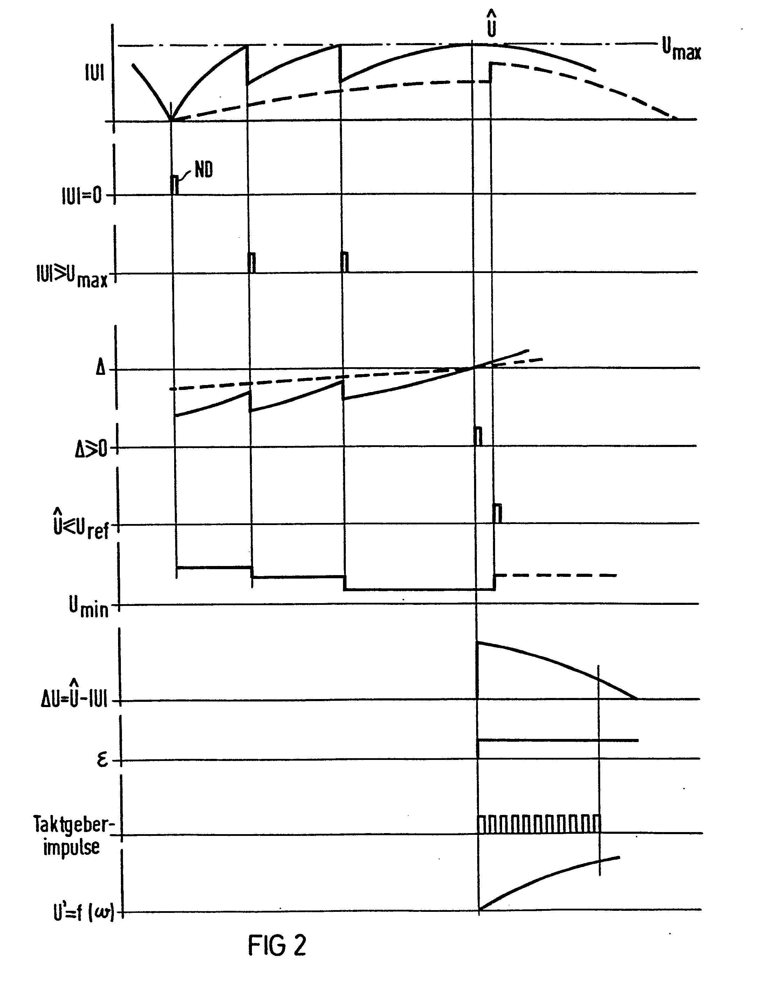

Figur 2 die zeitlichen Zusammenhänge der einzelnen elektrischen Größen.

Die zu messende, in ihrer Amplitude schwankende Wechselgröße $U = \hat{U}\sin\omega t$ sehr niedriger Frequenz $\omega$ (einige Hertz) wird einem Eingangsglied EG hoher Summenverstärkung mit durch eine Impulslogik JL stufenweise steuerbaren Verstärkungsfaktor zugeführt. Der Ausgang des Eingangsgliedes EG ist mit einem im wesentlichen aus einem hochverstärkenden Verstärker V2, Dioden D4, D5 und astabilen Kippstufen KS5 und KS6 sowie einem Oder-Glied O1 bestehenden Nulldurchgangsdetektor NDD sowie mit einem die verstärkte Wechselgröße gleichrichtenden Betragsbildner BB (Gleichrichterbrücke) verbunden. Der Ausgang des Betragsbildners BB ist mit mehreren Schaltungselementen unmittelbar verbunden, und zwar erstens mit einem von einem unabhängigen Taktgeber TG mit direkten und inversen Impulsen gesteuerten Differenzbildner DB, zweitens mit einer ersten Grenzwertstufe GW1, drittens mit einem Proben-Stufenspeicher SP2 und viertens subtrahierend mit einer Additionsstufe AD1.

Die besagte Ausgangsgröße des Eingangsgliedes EG wird im Betragsbildner BB in den Betrag |U| umgewandelt und in der Grenzwertstufe GW1 auf Überschreiten eines von den Verstärkereigenschaften des Eingangsgliedes EG bestimmten Grenzwertes Umax abgefragt. Sobald jeweils |U| = Umax wird, gibt die Grenzwertstufe GW1 ein Signal auf eine durch ansteigende Flanken angeregte Kippstufe KS1, die über ein UND-Gatter U1 den Vorwärtseingang eines ersten Zählers Z1 beeinflußt, so daß die Impulslogik JL jeweils im Sinne einer Herabsetzung des Verstärkungsfaktors des Eingangsgliedes EG um eine Stufe gesteuert wird und die Zahl der stufenweisen Rücknahme des Verstärkungsfaktors gezählt wird, wenn auch eine Kippstufe KS2 einen Impuls abgibt.

Der Ausgang der genannten Grenzwertstufe GW1 ist weiterhin über einen ansprechverzögernden Impulsgeber JG1 mit dem Abfrageeingang eines Proben-Stufenspeichers SP1 und wie gesagt über die astabile Kippstufe KS1 und das UND-Gatter U1 mit dem Vorwärtseingang des ersten Zählers Z1 verbunden und bildet mit der Ausgangsgröße der Kippstufe KS1 die « UND »-Bedingung vom UND-Gatter U1.

Die am Ausgang des Differenzbildners DB fortlaufend auftretenden einzelnen Amplitudendifferenzen Δ werden dem Proben-Stufenspeicher SP1 zugeführt. Nach Ansprechen der Grenzwertstufe GW1 bei |U| > Umax gibt der Impulsgeber JG1 auf den Proben-Stufenspeicher SP1 verzögert ein Abfragesignal, so daß der zuletzt zugeführte Wert der Amplitudendifferenz Δ auf eine der Kippstufe KS2 vorgeordnete Grenzwertstufe GW2 gelangt und dort mit einem Ansprechwert Δmin verglichen wird. Nur wenn der Wert Δ den besagten Ansprechwert Δmin erreicht bzw. überschreitet, wird von der durch ansteigende Flanken angeregten Kippstufe KS2 auf den Vorwärtseingang des Zählers Z1 ein Signal zur Rücknahme des Verstärkungsfaktors des Eingangsgliedes EG durch die Impulslogik IL gegeben. Dadurch wird die Rücknahme der Verstärkung kurz vor dem Scheitelwert vermieden.

Der Ausgang des Zählers Z1 ist zur Beeinflussung des Verstärkungsfaktors mit der Impulslogik IL verbunden, die sowohl auf das Eingangsglied EG wirkt als auch synchron und im gleichen Sinne wie das Eingangsglied EG gesteuert auf eine Verstärkungsschaltung HV für die stufenweise geänderte Verstärkung einer Hilfspannung $Umin_0$ zur Bildung einer Vergleichsspannung Umin, die zusammen mit der Ausgangsgröße des Proben-Stufenspeichers SP2 in einem Dividierer DIV zum Quotienten $\varepsilon = Umin/\hat{U}$ verarbeitet wird, der als eine Vergleichsgröße über eine Diode D3 dem einen Eingang einer Grenzwertstufe GW4 zugeführt wird. Dem anderen Eingang dieser Grenzwertstufe wird über eine Diode D2 der in der Additionsstufe AD1 gebildete Differenzwert $\Delta U = \hat{U} - |U|$ zugeführt.

Die Zunahme des Betrages |U| bis zum Erreichen bzw. Überschreiten des Maximalwertes Umax, der vorzugsweise dem Scheitelwert $\hat{U}$ der anstehenden Wechselgröße U entspricht, wird durch den Differenzbildner DB erfaßt, in dem in diesem entsprechend der Taktfrequenz der direkten und der inversen Impulse des Taktgebers TG der jeweilige Betrag |U| in zeitdiskrete Einzelwerte umgewandelt und aus diesen zusammengehörigen direkten bzw. inversen Einzelwerten die jeweilige Amplitudendifferenz Δ gebildet wird.

Der Betrag |U| zum Abfragezeitpunkt des Proben-Stufenspeichers SP2, bei dem über ein Oder-Gatter O2 beim Ansprechen einer von ansteigenden Flanken angeregten Kippstufe KS3 ein Abfragesignal auf den Proben-Stufenspeicher SP2 gelangt, sobald die von einem vorgeordneten Verstärker V1 verstärkte momentane Amplitudendifferenz Δ zu Null wird, entspricht dem Scheitelwert $\hat{U}$ der Wechselgröße. Wenn dieser Scheitelwert $\hat{U}$ einen gewählten Ansprechwert $U_{ref}$ einer Grenzwertstufe GW3 unterschreitet, d. h. kleiner Umax ist, wird eine durch ansteigende Flanken angeregte nachgeordnete Kippstufe KS4 betätigt und gibt ein Signal auf den Rückwärtseingang des Zählers Z1, der den Verstärkungsfaktor des Eingangsgliedes EG über die Impulslogik IL um eine Stufe erhöht. Abhängig vom Ansprechen der Kippstufen KS3 oder KS4 wird außer dem sofortigen Abfragen des Proben-Stufenspeichers SP2 ein Schaltglied SCH durch einen Impulsgeber IG2 verzögert betätigt, das den Inhalt $\hat{U}$ des Proben-Stufenspeichers SP2 zum Abfragezeitpunkt auf die Additionsstufe AD1 gibt, und dieser Wert dort mit dem später auftretenden Betrag |U| am Ausgang des Betragesbildners BB eine Spannungsdifferenz $\Delta U = U - |U|$ ergibt.

Der Ausgang des Verstärkers V1 ist über eine Diode D1 und die astabile Kippstufe KS3 an das Oder-Gatter O2 angeschlossen, dessen Ausgang sowohl mit dem Setzeingang S eines Gedächtnisses GE als auch mit dem Abfrageeingang des Proben-Stufenspeichers SP2 unmittelbar sowie über den zeitverzögernden Impulsgeber IG2 mit dem Steuereingang des Schaltgliedes SCH verbunden ist, das zwischen dem Ausgang des Proben-Stufenspeichers SP2 und der Additionsstufe AD1 angeordnet ist. Der Ausgang des Proben-Stufenspeichers SP2 ist ferner zusätzlich über die Grenzwertstufe GW3 und die astabile Kippstufe KS4 sowohl mit dem zweiten Eingang des Oder-Gatters O2 als auch mit dem Rückwärts-Eingang des Zählers Z1 zur Beeinflussung der Impulslogik IL im zunehmenden Sinn des Verstärkungsfaktors verbunden und ferner an den einen Eingang des Dividierers DIV angeschlossen.

Bei $\Delta U = \varepsilon$ gibt die Grenzwertstufe GW4 ein Rücksetzsignal auf den mit ihrem Ausgang verbundenen Rücksetzeingang R des Gedächtnisses GE. Der Ausgang des Gedächtnisses GE sowie der direkte Impulsausgang des Taktgebers TG sind mit den Eingängen eines UND-Gatters U2 verbunden, dessen Ausgang mit dem Vorwärtseingang eines Zählers Z2 verbunden ist, der die zwischen $\hat{U}$ und $\Delta U \geqslant \varepsilon$ auftretenden Impulse zählt.

Das Signal für den Rückwärtseingang des Zählers Z2 kommt über einen ansprechverzögernden Impulsgeber JG3 aus dem Ausgang des ODER-Gatters O1 des Nulldurchgangsdetektors NDD, der seine Nulldurchgangssignale ND außerdem unmittelbar der Impulslogik IL zur Erhöhung des Verstärkungsfaktors um eine Stufe zuführt.

Von der veränderlich verstärkten Ausgangsgröße U des Eingangsgliedes EG werden über den Nulldurchgangsdetektor NDD periodisch Nulldurchgangssignale ND erzeugt, die von Oder-Gatter O1 unverzögert der Impulslogik IL zur Erhöhung des letzten Verstärkungsfaktors um eine Stufe und als Rücksetzsignale verzögert dem Zähler Z2 sowie abwechselnd als Setz- und Rücksetzsignale für Register RE1 und RE2 unverzögert von den von steigenden bzw. fallenden Flanken angeregten astabilen Kippstufen KS5 und KS6 zugeführt werden. Die Ausgänge der Register RE1 und RE2 sind mit getrennten Eingängen eines codierte Impulse auf einen Digital-Analog-Wandler DAW abgebenden Summierers A verbunden. Die Setz- und Rücksetzeingänge S, R der Register RE1, RE2 sind jeweils mit den Kippstufen KS5 und KS6 so verbunden, daß die Register wechselweise arbeiten. Der Analogausgang des Digital-Analog-Wandlers DAW ist über zwei Parallelwege jeweils mit Eingängen einer Additionsstufe AD2 verbunden, deren Ausgang mit einer weiteren Additionsstufe AD3 unmittelbar verbunden ist. Der eine Parallelweg enthält ein Proportionalglied PG1 in Reihe mit einer Diode D6 und einem hochverstärkenden Verstärker V3, der andere subtrahierende Parallelweg nur ein Proportionalglied PG2.

Der Ausgang der Additionsstufe AD3 ist über die Reihenschaltung eines Proportionalgliedes PG3 mit einem Integrierglied INT auf seinen zweiten Eingang subtrahierend rückgeführt, an dem eine der Frequenz $\omega$ der Meßgröße U proportionale und für die Dauer einer Halbperiode konstant gehaltene Spannung U' abgreifbar ist.

## Patentansprüche

1. Verfahren zum Messen der Frequenz einer elektrischen Wechselgröße (U) unter Erfassung ihrer Nulldurchgänge und Umwandlung in Rechtecksignale (ND), die mit Zählimpulsen verglichen werden und bei dem die Impulsfolge zwischen jeweils zwei aufeinanderfolgenden Nulldurchgängen der Wechselgröße gespeichert und codiert in eine der jeweiligen Frequenz der Wechselgröße proportionale und zwischen den Nulldurchgängen konstante Spannung (U') umgewandelt wird, dadurch gekennzeichnet, daß zum Messen der nur einige Hertz betragenden Frequenz einer Wechselgröße mit stark schwankender Amplitude unter Ermittlung der jeweiligen Amplitude innerhalb jeder halben Periode die Wechselgröße (U) steuerbar stufenweise verstärkt, danach gleichgerichtet und ihr Betrag ($|U|$) mit einem vorgegebenen Maximalwert ($U_{max}$) verglichen, sowie aus dem Betrag ($|U|$) der Scheitelwert ($\hat{U}$) gebildet und beim Erreichen von Maximalwert ($U_{max}$) und Scheitelwert ($\hat{U}$) der Verstärkungsfaktor jeweils um eine Stufe vermindert wird, daß die Differenzspannung ($\Delta U$) aus dem Scheitelwert ($\hat{U}$) und einem Betrag der Wechselgröße gebildet und mit einem Quotienten ($\varepsilon$) aus dem Scheitelwert und einer synchron zur Wechselgröße in gleicher Weise verstärkungsgesteuerten Hilfsspannung ($U_{min}$) verglichen und aus der Zeitspanne zwischen dem Auftreten des Scheitelwertes ($\hat{U}$) und dem Gleichwerden der Differenzspannung mit dem Quotienten ($\varepsilon$) die dieser proportionale Impulsfolge gewonnen wird.

2. Schaltung zur Durchführung des Verfahrens nach Anspruch 1, mit einem Nulldurchgangsdetektor (NDD), einem unabhängigen Taktgeber (TG), einem von diesem und dem Nulldurchgangsdetektor (NDD) beaufschlagtem Zähler (Z2), sowie diesem nachgeordneten Register (RE) und Digital-Analog-Umwandler (DAW) dadurch gekennzeichnet, daß die Wechselgröße (U) über ein Eingangsglied (EG) mit stufenweise durch eine Impulslogik (IL) steuerbarem Verstärkungsfaktor einem Betragsbildner (BB) sowie dem Nulldurchgangsdetektor (NDD) zugeführt ist und von der Ausgangsgröße ($|U|$) des Betragsbildner (BB) sowohl ein bestimmter Maximalwert ($U_{max}$) als auch der Scheitelwert ($\hat{U}$) abgeleitet und ein in Abhängigkeit vom Auftreten beider Größen die Impulslogik (IL) stufenweise rücksetzend steuernder erster Zähler (Z1) vorgesehen ist, dessen Vorwärtszähleingang mit dem Ausgang eines ersten UND-Gatters (U1) verbunden ist, dessen Eingänge mit astabilen Kippstufen (KS1, KS2) verbunden sind, von denen die eine Kippstufe (KS1) über eine erste Grenzwertstufe (GW1) zur Erfassung des Maximalwertes ($U_{max}$) und die andere Kippstufe (KS2) über eine Grenzwertstufe (GW2) und einen abhängig vom Maximalwert abgefragten Proben-Stufenspeicher (SP1) sowie einen von dem Taktgeber (TG) impulsgesteuerten Differenzbildner (DB) mit dem Ausgang des Betragsbildners (BB) verbunden ist und ein in Abfrageabhängigkeit vom Scheitelwert ($\hat{U}$) gebrachter, mit dem Ausgang des Betragsbildners (BB) verbundener zweiter Proben-Stufenspeicher (SP2) ausgangsseitig sowohl mit einem zur Quotientenbildung dienenden Dividierer (DIV) als auch über ein beim Erreichen des Scheitelwertes verzögert ansprechendes Schaltglied (SCH) mit einer ersten Additionsstufe (AD1) zur Bildung der Differenzspannung (ΔU) verbunden ist, daß die Ausgänge von Dividierer (DIV) und Additionsstufe (AD1) jeweils mit einer Grenzwertstufe (GW4) verbunden sind, die ausgangsseitig den Rücksetzeingang (R) eines Gedächtnisses (GE) beaufschlagen, dessen Setzeingang (S) gleichzeitig mit dem Abfragen des zweiten Proben-Stufenspeichers (SP2) beaufschlagt ist, daß der Ausgang des Gedächtnisses (GE) sowie der Taktgeber (TG) auf ein UND-Gatter (U2) geführt sind, dessen Ausgang mit dem Setzeingang (S) des Zählers (Z2) verbunden ist, dessen Rücksetzeingang (R) in Abhängigkeit vom Nulldurchgangsdetektor (NDD) gebracht und der Ausgang des Zählers (Z2) mit zwei wechselweise in Abhängigkeit zum Nulldurchgangsdetektor (NDD) gesteuerten Registern (RE1, RE2) verbunden ist und daß die Impulse eines von den beiden Registern abhängigen, codierenden Summierers (A) dem Digital-Analog-Wandler (DAW) mit nachgeordneter Auswerteschaltung (AD2, AD3, PG1-3, INT) zur Umwandlung in eine frequenzproportionale Spannung (U') zugeführt sind.

3. Schaltung nach Anspruch 2, dadurch gekennzeichnet, daß der Ausgang des zweiten Proben-Stufenspeichers (SP2) über eine Grenzwertstufe (GW3) für eine Referenzspannung ($U_{ref}$) und eine astabile Kippstufe (KS4) mit dem Rücksetzeingang (R) des ersten Zählers (Z1) sowie über ein Oder-Gatter (O2) zum Abfragen des zweiten Proben-Stufenspeichers (SP2) mit dem Setzeingang (S) des Gedächtnisses (GE) verbunden ist.

**Claims**

1. A method of measuring the frequency of an alternating electrical magnitude (U) by determining its zero passages and forming rectangular signals (ND) which are compared with counting pulses, and wherein the pulse sequence between two consecutive zero passages of the alternating magnitude is stored and converted in coded fashion into a voltage (U') proportional to the respective frequency of the alternating magnitude and constant between the zero passages, characterised in that in order to measure the frequency of an alternating magnitude which is of only a few Hz and has a strongly fluctuating amplitude, by determining the respective amplitude within each half cycle, the alternating magnitude (U) is controllably amplified in stages, subsequently rectified and its value (|U|) is compared with a predetermined maximal value (Umax), and the peak value (Û) is formed from the value (|U|), and when obtaining the maximal value (Umax) and peak value (Û) the amplification factor is respectively reduced by one stage, that the difference voltage (ΔU) is formed from the peak value (Û) and a value of the alternating magnitude and compared with a quotient (ε) of the peak value and an auxiliary voltage (Umin) which is amplification-controlled in the same manner, in synchronism with the alternating magnitude and the pulse sequence proportional to the time interval being obtained from the time interval between the occurrence of the peak value (Û) and the equalization of the difference voltage to the quotient (ε).

2. A circuit for implementing the method as claimed in Claim 1, comprising a zero passage detector (NDD), an independent clock pulse generator (TG), a counter (Z2) acted upon by the latter and the zero passage detector (NDD), and registers (RE) and digital-analogue converters (DAW) which follow said counter, characterised in that the alternating magnitude (U) is supplied to a value forming unit (BB) and to the zero passage detector (NDD) by means of an input element (EG) having an amplification factor which can be controlled stepwise by a pulse logic (IL), and both a specific maximal value (Umax) and also the peak value (Û) are derived from the output magnitude (|U|) of the value forming unit (BB), and there is provided a first counter (Z1) which controls the pulse logic (IL) in a gradually resetting fashion in dependence upon both magnitudes and whose backward counting input is connected to the output of a first AND-gate (U1), whose inputs are connected to astable trigger stages (KS1, KS2), the one trigger stage (KS1) of which is connected to the output of the value forming unit (BB) by means of a first limit value stage (GW1) for determining the maximal value (Umax) and the other trigger stage (KS2) is connected to the output of the value forming unit (BB) by means of a limit value stage (GW2) and a sample step store (SP1), which is interrogated in dependence upon the maximal value, and a difference forming unit (DB) which is pulse-controlled by the clock pulse generator (TG), and at the output end a second sample step store (SP2) which has been brought into an interrogating dependence upon the peak value (Û) and is connected to the output of the value forming unit (BB) is connected both to a divider (DIV), which serves to form the quotient, and also to a first addition stage (AD1) for the formation of the difference voltate (ΔU) by means of a switching element (SCH) which responds in a delayed fashion when the peak value is obtained, that the outputs of the divider (DIV) and the addition stage (AD1) are respectively connected to a limit value stage (GW4), which at the output end acts upon the resetting input (R) of a memory (GE), whose setting input (S) is acted upon simultaneously with the interrogation of the second sample step store (SP2), that the output of the memory (GE) and the clock pulse generator (TG) are led to an AND-gate (U2), whose output is connected to the setting input (S) of the counter (Z2), whose resetting input (R) is brought into dependence upon the zero passage detector (NDD) and the output of the counter (Z2) is connected to two registers (RE1, RE2) which are alternately controlled in dependence upon the zero passage detector (NDD), and that the pulses of a coding summation amplifier (A) dependent upon the two registers are fed to the digital-analogue converter (DAW) having a following analyzing circuit (AD2, AD3, PG1-3, INT) for the conversion into a frequency-proportional voltage (U′).

3. A circuit as claimed in Claim 2, characterised in that the output of the second sample step store (SP2) is connected via a limit value stage (GW3) for a reference voltage ($U_{ref}$) and an astable trigger stage (KS4) to the resetting input (R) of the first counter (Z1) and to the setting input (S) of the memory (GE) by means of an OR-gate (O2) for interrogating the second sample step store (SP2).

**Revendications**

1. Procédé pour mesurer la fréquence d'une grandeur électrique alternative (U) avec détermination de ses passages par zéro et transformation en signaux rectangulaires (ND) qui sont comparés avec des impulsions de comptage, et dans lequel la succession d'impulsions entre chaque fois deux passages par zéro successifs de la grandeur alternative est mémorisée et est transformée avec codage en une tension (U′) proportionnelle à la fréquence instantanée de la grandeur alternative et constante entre les passages par zéro, caractérisé en ce que, pour mesurer la fréquence, qui n'est que de quelques hertz, d'une grandeur alternative dont l'amplitude varie fortement, avec détermination de l'amplitude instantanée à l'intérieur de chaque demi-période, la grandeur alternative (U) est amplifiée par échelons de façon commandée puis est redressée et sa valeur (|U|) est comparée avec une valeur maximale (Umax) préfixée, la valeur de crête (Û) étant formée de la valeur (|U|) et, lorsque la valeur maximale (Umax) et la valeur de crête (Û) sont atteintes, le facteur d'amplification est chaque fois réduit d'un échelon, que la tension différentielle (ΔU) est formée de la valeur de crête (Û) et d'une valeur de la grandeur alternative et est comparée avec un quotient (ε) de la valeur de crête et d'une tension auxiliaire (Umin) dont l'amplification est commandée en synchronisme avec la grandeur alternative et de la même manière et que, de l'intervalle de temps entre l'apparition de la valeur de crête (Û) et l'instant où la tension différentielle devient égale au quotient (ε), on tire la succession d'impulsions proportionnelle à celle-ci.

2. Montage pour la mise en œuvre du procédé selon la revendication 1, comprenant un détecteur de passage par zéro (NDD), une horloge (TG) indépendante, un compteur (Z2) actionné par cette horloge et par le détecteur du passage par zéro (NDD), de même qu'un registre (RE) et un convertisseur numérique-analogique (DAW) prévus à la suite de ce compteur, caractérisé en ce que la grandeur alternative (U) est appliquée à travers un élément d'entrée (EG), ayant un facteur d'amplification pouvant être commandé de façon échelonnée par une logique à impulsions (IL), à un formateur de valeur (BB) ainsi qu'au détecteur de passage par zéro (NDD) et qu'une valeur maximale déterminée (Umax) de même que la valeur de crête (Û) sont tirées de la grandeur de sortie (|U|) du formateur de valeur (BB), qu'un premier compteur (Z1) est prévu qui commande en fonction de l'apparition de ces deux grandeurs la logique à impulsions (IL) dans le sens de la réduction échelonnée, l'entrée de comptage positif de ce premier compteur étant connectée à la sortie d'une première porte ET (U1) dont les entrées sont connectées à des bascules astables (KS1, KS2) dont l'une (KS1) est connectée à travers un premier étage de valeur limite (GW1) pour la détermination de la valeur maximale (Umax) et dont l'autre bascule (KS2) est connectée à travers un étage de valeur limite (GW2) et une mémoire d'échelons d'essai (SP1) interrogée en fonction de la valeur maximale, ainsi qu'à travers un formateur de différence (DB) commandé par impulsions par l'horloge (TG), à la sortie du formateur de valeur (BB) et qu'une deuxième mémoire d'échelons d'essai (SP2), dont l'interrogation est rendue dépendante de la valeur de crête (Û) et qui est connectée à la sortie du formateur de valeur (BB), et reliée, côté sortie, à la fois à un diviseur (DIV) servant à la formation du quotient et, à travers un élément de commutation (SCH) réagissant de façon retardée lorsque la valeur de crête est atteinte, à un premier étage d'addition (AD1) pour la formation de la tension différentielle (ΔU), que les sorties du diviseur (DIV) et de l'étage d'addition (AD1) sont reliées chacune à un étage de valeur limite (GW4), étages qui agissent par leur sortie sur l'entrée de remise à O (R) d'une mémoire (GE), dont l'entrée de mise à 1 (S) est actionnée simultanément avec l'interrogation de la deuxième mémoire d'échelons d'essai (SP2), que la sortie de la mémoire (GE) et l'horloge (TG) sont reliées à une porte ET (U2), dont la sortie est connectée à l'entrée de mise à 1 (S) du compteur (Z2), dont l'entrée de remise à O (R) est rendue dépendante du détecteur de passage par zéro (NDD), la sortie du compteur (Z2) étant reliée à deux registres (RE1, RE2) qui sont commandés alternativement en fonction du détecteur de passage par zéro (NDD) et que les impulsions d'un additionneur codeur (A), qui dépend des deux registres, sont appliquées au convertisseur numérique-analogique (DAW), suivi d'un montage d'exploitation (AD2, AD3, PG1-3, INT) pour la conversion en une tension (U′) proportionnelle à la fréquence.

3. Montage selon la revendication 2, caractérisé en ce que la sortie de la deuxième mémoire d'échelons d'essai (SP2) est reliée à travers un étage de valeur limite (GW3) pour une tension de référence ($U_{ref}$) et une bascule astable (KS4) à l'entrée de remise à O (R) du premier compteur (Z1) et à travers une porte OU (O2) en vue de l'interrogation de la deuxième mémoire d'échelons d'essai (SP2) à l'entrée de mise à 1 (S) de la mémoire (GE).

FIG 1

FIG 2